# EUROPEAN PATENT APPLICATION

(11) **EP 4 401 131 A1**
(43) Date of publication of application: **17.07.2024**
(21) Application number: 23151391.2
(22) Date of filing: 12.01.2023
(51) Int. Cl.: H01L 23/495

(54) **A SEMICONDUCTOR PACKAGE IN A SOURCE-DOWN CONFIGURATION BY USE OF VERTICAL CONNECTORS**

(71) Applicant: Infineon Technologies Austria AG, 9500 Villach (AT)
(72) Inventor: FUERGUT, Edward, 86453 Dasing (DE); OTREMBA, Ralf, 87600 Kaufbeuren (DE); TREU, Julian, 81543 München (DE); GAN, Thai Kee, 75200 Melaka Tengah (MY); BOEHM, Marcus, 93098 Mintraching (DE)
(74) Representative: Lambsdorff & Lange Patentanwälte Partnerschaft mbB

(57) **Abstract**

A semiconductor package (10; 20; 30) comprising a leadframe (11; 21) comprising a die carrier (11.1) and at least one first lead (11.2; 21.2) connected with the die carrier (11.1; 21.1), a semiconductor transistor die (12) connected with the die carrier (11.1; 21.1) and comprising a first surface and a second surface opposite to the first surface, a source pad (12.1) disposed on the first surface and a drain pad disposed on the second surface, wherein the first surface faces a bottom side of the semiconductor package (10; 20; 30) and the second surface faces a top side of the package (10; 20; 30), and a clip (13) wherein the source pad (12.1) is connected with the clip (13) by at least one electrical connector (14).

## Description

### TECHNICAL FIELD

The present disclosure is related to a semiconductor package, in particular to a semiconductor transistor package in a source-down configuration.

### BACKGROUND

Discrete power semiconductor packages are usually designed with a collector/drain down concept. That means the backside of the semiconductor transistor die (collector/drain contact) is attached to the leadframe and the frontside interconnect (emitter/source/sense/gate) is connected to the lead contacts e.g. SMD (surface mount device) lead or THT (through-hole technology) pin. In this configuration certain electrical and thermal disadvantages have to be faced.

In particular, a drain down package concept requires full isolation between the die pad and the application heatsink which can be a cost adder at system level. This isolation has in many application issues in terms of EMV or even capacitive power losses (lower efficiency, higher heat dissipation). Furthermore a drain down package concept has limitations in terms of Rd_{s(On)} and parasitics (lower electrical performance on system level).

These disadvantages could be overcome for discrete power devices using a source down package concept leading to big advantages within the application. Source Down for (SMD) surface mount devices is currently very successful in the low voltage class up to 100V, and the demand is increasing in the field of high voltage devices e.g. 650V & 1200V or even above. In the field of WBG (wide band gap) devices e.g. SiC-MOS and GaN, the efficiency of the components are no longer sufficient to meet the upcoming requirements on system level. Improvements on WBG devices on system level can easier be paid off with a cost adder on package level.

For these and other reasons there is a need for the present disclosure.

### SUMMARY

An aspect of the present disclosure is related to a semiconductor package comprising a leadframe comprising a die carrier and at least one first lead connected with the die carrier, a semiconductor transistor die connected with the die carrier and comprising a first surface and a second surface opposite to the first surface, a source pad disposed on the first surface and a drain pad disposed on the second surface, wherein the first surface faces a bottom side of the semiconductor package and the second surface faces a top side of the package, and a clip wherein the source pad is connected with the clip by at least one electrical connector.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows an example of a semiconductor package with a single gauge leadframe and vertical wires between the source pad and the clip in a schematic cross-sectional side view.
Fig. 2 shows the semiconductor package of Fig. 1 in a perspective view from below.
Fig. 3 shows the semiconductor package of Fig. 1 in a perspective view from below before mounting the clip and applying the encapsulant.
Fig. 4 shows an example of a semiconductor package with a dual gauge leadframe and wires between the source pad and the clip in a schematic cross-sectional side view.
Fig. 5 shows the semiconductor package of Fig. 4 in a perspective view from below.
Fig. 6 shows an example of a semiconductor package with a single gauge leadframe and wire loops between the source pad and the clip in a perspective view from below.
Fig. 7 comprises Fig. 7A to 7D and shows three different types of electrical connectors to be connected between the source pad and the clip, namely vertical wires (A), vertical wire loops (B), stacked stud bumps (C), and a single piece of wire (D).

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

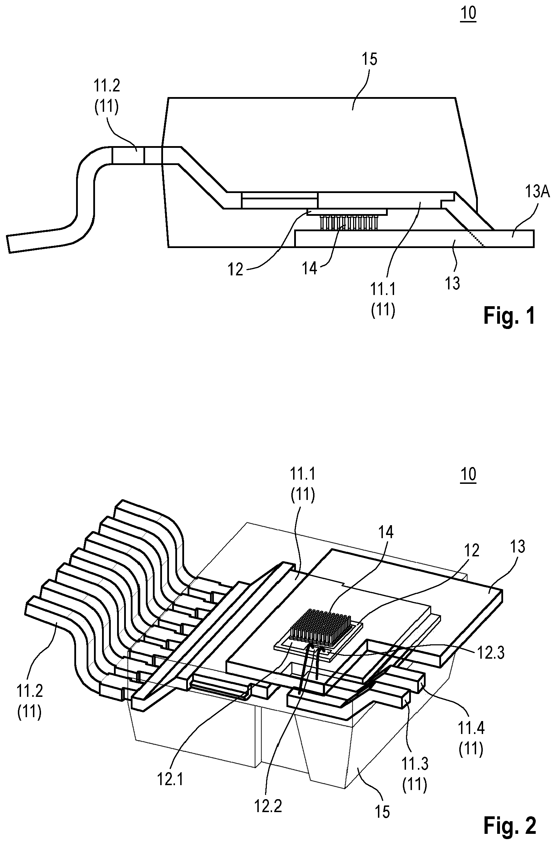

Figs. 1, 2 and 3 show an example of a semiconductor package with a single gauge leadframe and vertical wires between the source pad 12.1 and the clip.

More specifically, the semiconductor package 10 of Figs. 1, 2 and 3 comprise a leadframe 11 comprising a die carrier 11.1 and a plurality of first leads 11.2 connected with the die carrier 11.1. The semiconductor package 10 further comprises a semiconductor transistor die 12 which is connected with the die carrier 11.1. The semiconductor die 12 can, for example, be one or more of a vertical transistor die, a MOSFET die, and an IGBT die. Furthermore the semiconductor die 12 can be fabricated from Si, or from a wide bandgap semiconductor material like SiC or GaN.

The semiconductor transistor die 12 can in particular comprise a power semiconductor transistor die. Here, the term "power semiconductor transistor die" may refer to a semiconductor die providing at least one of high voltage blocking or high current-carrying capabilities. A power semiconductor die may be configured for high currents having a maximum current value of a few Amperes, such as e.g. 10 A, or a maximum current value of up to or exceeding 100 A. Similarly, voltages associated with such current values may have values of a few Volts to a few tens or hundreds or even thousands of Volts.

The semiconductor transistor die 12 comprises a first surface and a second surface opposite to the first surface, a source pad 12.1 disposed on the first surface and a drain pad disposed on the second surface, wherein the semiconductor transistor die 12 is connected with the drain pad to the die carrier 11.1. The source pad 12.1 faces a bottom side of the package and the drain pad faces a top side of the package so that the package is configured in a source-down mode. The down side of the package can be the mounting side of the package, the device being thus an SMD (surface mount device.

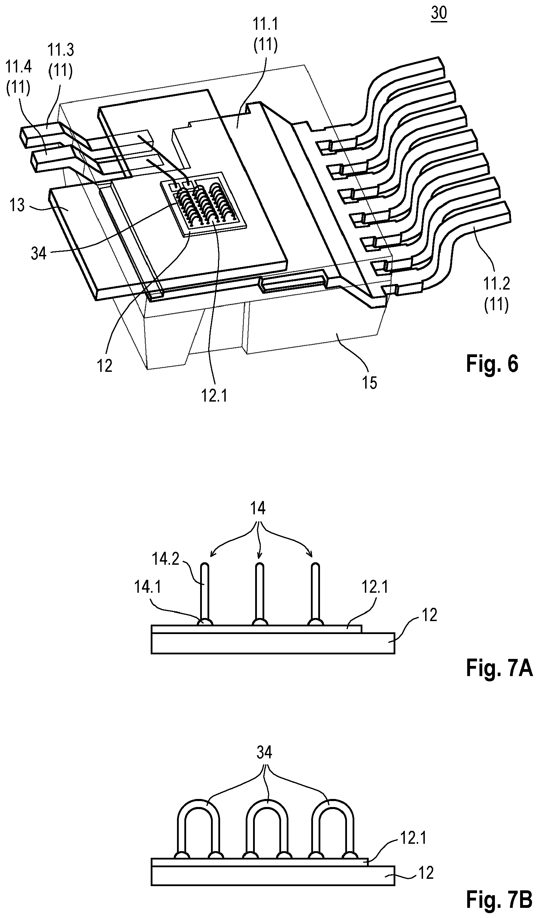

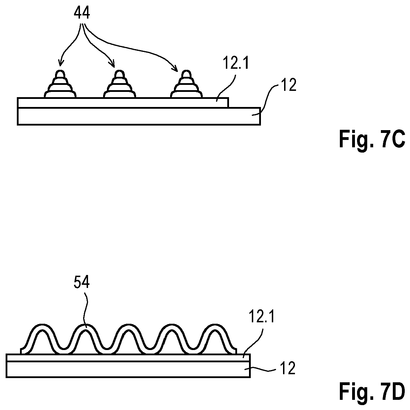

The semiconductor package 10 further comprises a clip 13 wherein the source pad 12.1 is connected with the clip by electrical connectors 14, in particular vertical electrical connectors 14. In the example as shown in Figs. 1, 2 and 3 the electrical connectors 14 are given by electrical wires 14, in particular vertical electrical wires 14. Exemplary details of the electrical wires 14 and other examples of electrical connectors 14 are shown and explained in connection with Fig. 7.

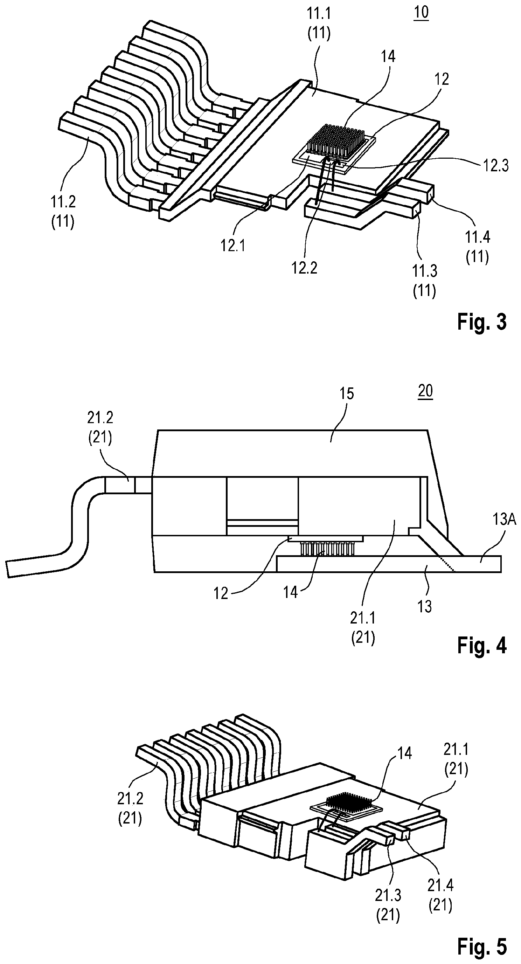

As can be seen in Figs. 2 and 3, the electrical wires 14 can be arranged in the form of a matrix like arrangement along equally spaced rows and columns. The number, the spatial dimensions of the electrical wires 14 and their distances from each other can be specifically chosen to create a desired thermal resistance between the source pad 12.1 and the clip 13. It may be desired, for example, to provide a good or satisfactory electrical transition between the source pad 12.1 and the clip 13 on the one hand, but on the other hand to provide a thermal resistance between the source pad 12.1 and the clip 13 that is higher than the thermal resistance between the drain pad and the die carrier, e.g. 2 times, or 5 times, or 10 times higher than the thermal resistance between the drain pad and the die carrier. This can be used to protect a printed circuit board, to which the package is connected with its clip, from too high temperatures. For example, whereas an expected chip temperature can be in a range from 175°C to 200°C, adjusting the thermal resistance between the source pad and the clip can be done so that the temperature of the PCB will be limited to a range of Tmax in a range of 100°C to 150°C.

The semiconductor package further comprises an encapsulant 15 covering the die carrier 11, the semiconductor die 12, and at least partially covering the clip 13.

The encapsulant 15 may be comprised of a conventional mold compound like, for example, a resin material, in particular an epoxy resin material. Moreover, the encapsulant 15 can be applied in different aggregate states as, for example, in liquid form, as pellets, or as a granulate. Moreover, the encapsulant 15 can be made of a thermally conductive material to allow efficient heat dissipation to external application heat sinks. The material of the encapsulant 15 can, in particular, comprise a resin like an epoxy resin material filled with particles like, for example, SiO or other ceramic particles, or thermally conductive particles like, for examples, Al₂O₃, BN, AlN, Si₃N₄, diamond, or any other thermally conductive particles. The encapsulant 15 can also be made of a plateable mold compound.

The semiconductor transistor die 12 may further comprise a gate pad 12.2 and a source-sense pad 12.3, both being disposed on the first main face. The gate pad 12.2 can be connected to a second lead 11.3 and the source/sense pad 12.3 can be connected to a third lead 11.4. The second and third leads 11.3 and 11.4 may comprise inner portions which are located in the same plane as the chip carrier 11.1 and outer portions which are located in the plane of the clip 13. The second and third leads 11.3 and 11.4 may be components of the lead frame 11, as are the first leads 11.2 and the chip carrier 11.1.

As shown in Fig. 3, the die carrier 11.1 has a basically rectangular shape, but has a rectangular recess at one of its 4 corners, in which the inner portions of the second and third leads 11.3 and 11.4 are arranged. The gate pad 12.2 and the source sense pad 12.3 can be connected to the inner portions of the second and third leads 11.3 and 11.4 by bonding wires.

As shown in Fig. 2, the clip 13 also has a basically rectangular shape, but it also has a rectangular recess at one of its four corners, in which the outer portions of the second and third leads 11.3 and 11.4 are arranged. The clip 13 has an outer section 13A which is not embedded by the encapsulant 15 and extends to the outside from the encapsulant 15 like the outer portions of the second and third leads 11.3 and 11.4.

The second and third leads 11.3 and 11.4 also have bent portions that connect the inner and outer portions of the second and third leads 11.3 and 11.4 with each other and are located within the encapsulant 15.

The plurality of first leads 11.2 comprise outer end portions and portions that lie in a plane above the plane of the die carrier 11.1. These portions are interconnected by bent portions. The first leads 11.2 may be located entirely outside the encapsulant. The first leads 11.2 may be connected to a lateral bar which can be arranged inside the encapsulant 15.

The plurality of first leads 11.2 are located on a first side of the encapsulant 15 and the external portion 13A of the clip 13 and the second and third leads 11.3 and 11.4 are located on a second side of the encapsulant 15 opposite to the first side.

As already mentioned above, the leadframe of the example of Figs. 1 to 3 is a single gauge leadframe. "Gauge" is to do with the thickness of the die carrier provided for the package. Single gauge means a thickness of 0.5 mm of the die carrier and dual gauge means a thickness of 1.2 mm of the die carrier wherein these thickness values are mot to be understood in any way restrictive. In the following an example of a semiconductor package having a dual gauge leadframe will be shown.

Figs. 4, 5 and 6 show alternative examples of semiconductor packages with a dual gauge leadframe in a side view (Fig. 4), the semiconductor package of Fig. 4 in a perspective view (Fig. 5), and a semiconductor package with a single gauge leadframe and wire loops as vertical connectors.

The semiconductor package 20 of Fig. 4 is similar to the semiconductor package 10 so that the same reference signs were used for the same parts. The only difference to the semiconductor package 10 is that it comprises a dual gauge leadframe 21 which means that the leadframe 21 comprises a die carrier 21.1 which comprises a thickness which is more than twice the thickness of the carrier 11.1 of the leadframe 11. This increased thickness allows for improved dissipation of excess heat from the package due to improved internal heat spreading.

The semiconductor package 30 of Fig. 6 is similar to the semiconductor package 10 of Fig. 1 so that the same reference signs were used for the same parts. The only difference to the semiconductor package 10 is the plurality of electrical connectors 34 which in this case are comprised of a plurality of wire loops, in particular vertical wire loops 34.

The electrical wire loops 34 can be arranged in the form of a matrix like arrangement along equally spaced rows and columns. The number, the spatial dimensions of the electrical wire loops 34 and their distances from each other can be specifically chosen to create a desired thermal resistance between the source pad 12.1 and the clip 13 as was already explained above in connection with the electrical wires 14 of the semiconductor package 10.

The semiconductor packages 10, 20, or 30 can be applied to standard discrete power packages, e.g. TO263, TO252, or TOLL, as well as through-hole devices (THD), e.g., TO252 or TO247.

The semiconductor packages of the present disclosure can be applied for one or both of top-side cooling and down side cooling. In particular, for top side cooling it is possible to expose the die carrier to the outside on top of the package, in particular for the semiconductor package 20 of Fig. 4. In this case the encapsulant 15 would not cover the die carrier on the top side. Another application is double-side cooling (DSC), in which both drain and source contacts would be exposed.

In order to provide system-in-package (SiP) solutions, it is also possible to combine any one of the source-down semiconductor die configurations of the present disclosure with a source-up semiconductor die configuration in one package. Alternatively or in combination, it is also possible to integrate a driver device, for example by placing the driver device onto one of the leads of the leadframe.

Fig. 7 comprises Fig. 7A to 7C and shows three different types of electrical connectors to be connected between the source pad 12.1 and the clip, namely vertical wires (A), vertical wire loops (B), and stacked stud bumps (C).

According to Fig. 7A, the electrical connectors are provided by vertical electrical wires 14. The electrical wires 14 can be fabricated e.g. by nail head bonding in which case nail head 14.1 is at first deposited onto the upper main surface of the source pad 12.1 of the semiconductor transistor die 12. Subsequently a vertical wire 14.2 will be bonded on top of the nail head 14.1. After fabricating the plurality of vertical wires 14, a clip 13 will be applied on top of the plurality of vertical wires 14. Alternatively, the vertical wires 14 could be connected to the source pad 21.1 using other methods such as solder or a conductive glue.

As was explained above, the vertical wires 14 can be fabricated to adjust a desired value of the thermal resistance between the source pad 12.1 and the clip 13. The available parameters therefore are the wire size (diameter), the wire length, the nail head width (at the bottom), and the wire pitch (distance between wires). For limiting the temperature of the PCB to a range from 100°C - 150°C board the following range are expected to be adequate and sufficient.
Wire size: 25 µm - 100 µm
Wire length: 100 µm - 2000 µm
Nail head width: 100 µm - 200 um
Wire pitch: 110 µm - 250 µm.

If it is not desired to adjust the temperature resistance between the source pad and the clip, the above parameter ranges can be applied in combination or separately.

According to Fig. 7B, the at least one electrical connector is provided by vertical electrical wire loops 34 as was shown in the example of a semiconductor package 30 in Fig. 3. The two joints of each one of the wire loops 34 with the source pad 12.1 can be fabricated e.g. by nail head bonding like with the vertical wires 14 of Fig. 7A. Alternatively, the wire loops 34 could be connected to the source pad 21.1 using other methods such as solder or a conductive glue.

According to Fig. 7C, the at least one electrical connector is provided by stacked stud bumps 44. A minimal height of each one of the stacked stud bumps 44 can be in the order of 100 µm.

According to Fig. 7D, the at least one electrical connector is provided by a single piece of wire 54. The joints of the single piece of wire 54 with the source pad 12.1 can be fabricated e.g. by nail head bonding like with the vertical wires 14 of Fig. 7A.

### EXAMPLES

In the following specific Examples of the present disclosure are described.

Example 1 is a semiconductor package, comprising a leadframe comprising a die carrier and at least one first lead connected with the die carrier, a semiconductor transistor die connected with the die carrier and comprising a first surface and a second surface opposite to the first surface, a source pad disposed on the first surface and a drain pad disposed on the second surface, wherein the first surface faces a bottom side of the semiconductor package and the second surface faces a top side of the semiconductor package, and a clip wherein the source pad is connected with the clip by at least one electrical connector.

Example 2 is the semiconductor package according to Example 1, wherein the source pad is connected with the clip by a plurality of electrical connectors.

Example 3 is the semiconductor package according to Example 2, wherein the plurality of electrical connectors comprise a plurality of wires connected between the source pad and the clip.

Example 4 is the semiconductor package according to Example 2, wherein the plurality of electrical connectors comprises a plurality of wire loops connected between the source pad and the clip.

Example 5 is the semiconductor package according to 2, wherein the plurality of electrical connectors comprises a plurality of stacked stud bumps connected between the source pad and the clip.

Example 6 is the semiconductor package according to Example 1, wherein the at least one electrical connector comprises a single piece of wire.

Example 7 is the semiconductor package according to any one of the preceding Examples, further comprising a gate pad disposed on the first surface and connected to a second lead.

Example 8 is the semiconductor package according to Example 7, further comprising a source/sense pad disposed on the first surface and connected to a third lead.

Example 9 is the semiconductor package according to any one of the preceding Examples, further comprising an encapsulant at least partially covering the die carrier, the semiconductor die and the clip.

Example 10 is the semiconductor package according to Example 9, wherein the clip comprises an external portion which is not covered by the encapsulant, and the at least one first lead is located on a first side of the encapsulant and the external portion of the clip is located on a second side of the encapsulant opposite to the first side.

Example 11 is the semiconductor package according to Examples 8 to 10, wherein the at least one first lead is located on a first side of the encapsulant and the second and third leads are located on a second side of the encapsulant opposite to the first side.

Example 12 is the semiconductor package according to any one of the preceding Examples, wherein the semiconductor package is configured as a surface mount device.

Example 13 is the semiconductor package according to any one of the preceding Examples, wherein the at least one electrical connector is connected to the source pad via nail contacts.

Example 14 is the semiconductor package according to any one of the preceding Examples, wherein the at least one electrical connector is configured so that a thermal resistance between the source pad and the clip is higher than a thermal resistance between the drain pad and the die carrier.

Example 15 is the semiconductor package according to Example 14, wherein the at least one electrical connector is configured so that a thermal resistance between the source pad and the clip is 2 or more times, 5 or more times, or 10 or more times higher than the thermal resistance between the drain pad and the die carrier.

Example 16 is the semiconductor package according to any one of the preceding examples, wherein the leadframe is configured as a single gauge leadframe.

Example 17 is the semiconductor package according to any one of Examples 1 to 15, wherein the leadframe is configured as a dual gauge leadframe.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor package (10; 20; 30), comprising:
- a leadframe (11; 21) comprising a die carrier (11.1) and at least one first lead (11.2; 21.2) connected with the die carrier (11.1; 21.1);
- a semiconductor transistor die (12) connected with the die carrier (11.1; 21.1) and comprising a first surface and a second surface opposite to the first surface, a source pad (12.1) disposed on the first surface and a drain pad disposed on the second surface, wherein the first surface faces a bottom side of the semiconductor package (10; 20; 30) and the second surface faces a top side of the semiconductor package (10; 20; 30); and
- a clip (13) wherein the source pad (12.1) is connected with the clip (13) by at least one electrical connector (14; 34; 44; 54) .

2. The semiconductor package (10; 20; 30) according to claim 1, wherein
the source pad (12.1) is connected with the clip (13) by a plurality of electrical connectors (14; 34; 44).

3. The semiconductor package (10; 20; 30) according to claim 2, wherein
the plurality of electrical connectors (14) comprise a plurality of wires (14) connected between the source pad (12.1) and the clip (13).

4. The semiconductor package (10; 20; 30) according to claim 2, wherein
the plurality of electrical connectors (34) comprise a plurality of wire loops (34) connected between the source pad (12.1) and the clip (13).

5. The semiconductor package (10; 20; 30) according to claim 2, wherein
the plurality of electrical connectors (44) comprise a plurality of stacked stud bumps (44) connected between the source pad (12.1) and the clip (13).

6. The semiconductor package (10; 20; 30) according to claim 1, wherein
the at least one electrical connector (54) comprises a single piece of wire (54).

7. The semiconductor package (10; 20; 30) according to any one of the preceding claims, further comprising
- a gate pad (12.2) disposed on the first surface and connected to a second lead (11.3; 21.3).

8. The semiconductor package (10; 20; 30) according to claim 7, further comprising
- a source/sense pad (12.3) disposed on the first surface and connected to a third lead (11.4; 21.4).

9. The semiconductor package (10; 20; 30) according to any one of the preceding claims, further comprising
- an encapsulant (15) at least partially covering the die carrier (11.1), the semiconductor die (12) and the clip (13).

10. The semiconductor package (10; 20; 30) according to claim 9, wherein
the clip (13) comprises an external portion (13A) which is not covered by the encapsulant (15), and
the at least one first lead (11.2) is located on a first side of the encapsulant (15) and the external portion (13A) of the clip (13) is located on a second side of the encapsulant (15) opposite to the first side.

11. The semiconductor package (10; 20; 30) according to claims 8 to 10, wherein
the at least one first lead (11.2) is located on a first side of the encapsulant (15) and the second and third leads (11.3, 11.4) are located on a second side of the encapsulant (15) opposite to the first side.

12. The semiconductor package (10; 20; 30) according to any one of the preceding claims, wherein
the semiconductor package (10; 20; 30) is configured as a surface mount device.

13. The semiconductor package (10; 20; 30) according to any one of the preceding claims, wherein
the at least one electrical connector (14) is connected to the source pad (12.1) via nail contacts.

14. The semiconductor package (10; 20; 30) according to any one of the preceding claims, wherein
the at least one electrical connector (14) is configured so that a thermal resistance between the source pad (12.1) and the clip (13) is higher than a thermal resistance between the drain pad and the die carrier (11.1).

15. The semiconductor package (10; 20; 30) according to claim 14, wherein
the at least one electrical connector (14) is configured so that a thermal resistance between the source pad (12.1) and the clip (13) is 2 or more times, 5 or more times, or 10 or more times higher than the thermal resistance between the drain pad and the die carrier.

16. The semiconductor package (10) according to any one of the preceding claims, wherein
the leadframe (11) is configured as a single gauge leadframe (11) .

17. The semiconductor package (20) according to any one of claims 1 to 15, wherein
the leadframe (21) is configured as a dual gauge leadframe (21) .
